# EUROPEAN PATENT APPLICATION

(11) **EP 4 645 345 A1**
(43) Date of publication of application: **05.11.2025**
(21) Application number: 25173873.8
(22) Date of filing: 01.05.2025
(51) Int. Cl.: H01B 11/18, H01J 37/18, H02G 11/00

(54) **ELECTRICAL AND THERMAL CONNECTION CABLE FOR CHARGED PARTICLE MICROSCOPES**

(30) Priority: 03.05.2024 US 202418654306
(71) Applicant: FEI Company, Hillsboro, OR 97124 (US)
(72) Inventor: WENSVEEN, Marcel, Woudrichem (NL); VAN DEN BOOGAARD, Mathijs Petrus Wilhelmus, Oirschot (NL)
(74) Representative: Boult Wade Tennant LLP

(57) **Abstract**

Systems, methods, and communication cables taught herein provide cryogenic cooling, high voltage connections, and other electrical connections to a sample on a stage within a vacuum environment while still enabling stage motion in at least five degrees of freedom with minimal stage vibration to enable new or improved measurement applications in-situ within the microscope such as atom probe tomography and testing of quantum computing components. The connection cables taught herein combine connections into a single connection cable within an outer spring that is suitable for use in ultra-high vacuum. The connection cables are also shaped and configured to maintain at least a minimum standoff distance from components in the nearby environment (e.g., chamber walls and other equipment) to prevent mechanical, electrical, and thermal shortcutting.

## Description

### BACKGROUND

Atom probe tomography (APT) proceeds by evaporating a needle shaped sample and derives information on the structure, composition, and/or morphology of the sample by progressive measurements of atoms removed from the surface of the sample. Information about the morphology, structure and compositional changes of the sample during the process are important for avoiding artifacts in APT data. Combining an APT tool within a charged particle microscope (such as an electron microscope) affords new information that enhances 3D reconstruction information of the sample, as well as improves overall APT performance. The APT tool can be combined with scanning and/or transmission electron microscopy techniques.

Typically, charged particle microscopy information about the shape, structure and composition of the needle is used as an input for the APT reconstruction at the beginning of an APT experiment and at the end of an experiment, owing at least to the significant challenges with sample re-alignment during an APT experiment that would be faced when removing the sample from the APT instrument to the microscope to update microscope data. There is a need, therefore, for systems, methods, and algorithms, for switching between APT operation and scanning or transmission charged particle (e.g., electron) microscopy (S/TEM) operation in situ, to improve the correlation between the two different information channels and to reduce artifacts in APT data.

### BRIEF SUMMARY

A connection cable for electrical and thermal connectivity in ultra-high vacuum is provided in accordance with some examples taught herein. The connection cable includes an outer spring including a lumen extending therethrough. The outer spring includes vacuum conductance paths to enable evacuation of the lumen in a vacuum environment. The connection cable includes a braid located at least partially within the lumen of the outer spring and configured to conduct high voltage and thermal energy. The connection cable includes an inner structural element disposed at least partially within the braid to maintain the shape of the connection cable.

A method of manufacturing a connection cable that provides electrical and thermal connectivity is provided in accordance with some examples taught herein. The method includes expanding an end of an outer spring. The outer spring includes a lumen extending therethrough. The method includes inserting an inner structural element into a braid. The method includes inserting the braid and inner structural element into the lumen of the outer spring.

A connection cable for electrical and thermal connectivity in ultra-high vacuum is provided in accordance with some examples taught herein. The connection cable includes a first section configured to enable motion of a connected stage in three translational dimensions and a first rotational dimension. The first section includes an outer spring including a first lumen extending therethrough. The first section includes a braid disposed at least partially within the first lumen of the outer spring and configured to conduct high voltage and thermal energy. The first section includes an inner structural element disposed at least partially within the braid to maintain the shape of the first section. The connection cable includes a second section configured to enable motion of the connected stage in a second rotational dimension. The second section includes the braid. The connection cable includes an intermediate fixation that connects the first section and the second section.

### BRIEF DESCRIPTION OF THE SEVERAL VIEWS OF THE DRAWINGS

To easily identify the discussion of any particular element or act, the most significant digit or digits in a reference number refer to the figure number in which that element is first introduced.

It is to be understood that the figures are not necessarily drawn to scale, nor are the objects in the figures necessarily drawn to scale in relationship to one another. The figures are depictions that are intended to bring clarity and understanding to various embodiments of apparatuses, systems, and methods disclosed herein. Wherever possible, the same reference numbers will be used throughout the drawings to refer to the same or like parts. Moreover, it should be appreciated that the drawings are not intended to limit the scope of the present teachings in any way.
FIG. 1 illustrates a schematic of a connection cable for operation in an ultra-high vacuum environment in accordance with various examples taught herein.
FIG. 2 illustrates a cross-sectional view through a section of the connection cable.
FIG. 3 illustrates a view of an interior of an intermediate fixation of the connection cable in accordance with some examples taught herein.
FIG. 4 illustrates a cross-sectional view of an end of the connection cable in accordance with some examples taught herein.
FIG. 5 illustrates a schematic view of the connection cable as taught herein within an example charged particle system.
FIG. 6 illustrates a schematic view of the electrical and thermal systems of the charged particle system including the connection cable attached to an example stage according to various examples taught herein.
FIG. 7 illustrates a schematic view of a longitudinal cross section of a portion of the connection cable.
FIG. 8A illustrates a perspective view of an example connection cable connected to the stage in a neutral tilt position.
FIG. 8B illustrates the same connection cable as in FIG. 8A wherein the view of the connection cable 100 is overlaid in three beta-angle tilt states.
FIG. 8C illustrates the same connection cable as in FIG. 8A wherein the view of the connection cable 100 is overlaid in three alpha-angle tilt states.
FIG. 8D illustrates a side view of the connection cable attached to a stage within an ultra-high vacuum environment.
FIG. 9 illustrates a method of manufacturing a connection cable according to some examples taught herein.

### DETAILED DESCRIPTION

Systems, methods, and communication cables taught herein provide cryogenic cooling, high voltage connections, and other electrical connections to a sample on a stage within a vacuum environment while still enabling stage motion in at least five degrees of freedom with minimal stage vibration. In existing conventional systems, the thermal connection, high voltage connection, and electrical sensor connections had to be provided separately. The provision of separate connections with varying degrees of stiffness and/or slack creates a danger of contacting the connections to the surrounding environment leading to short circuits, loss of cooling, or damage to components. Similarly, separate connections provide individual sources of unwanted vibrational motion (leading to poor imaging) and can create a large effective load restricting stage travel or leading to motion hysteresis. The connection cables taught herein overcome these issues by combining connections into a single connection cable within an outer spring that is suitable for use in ultra-high vacuum. These connection cables enable new or improved measurement applications in-situ within the microscope such as atom probe tomography and testing of quantum computing components where both cryogenic temperatures and access to electrical sensing and testing equipment are desired at the stage while the stage retains precision motion in five degrees of freedom. The connection cables are also shaped and configured to maintain at least a minimum standoff distance from components in the nearby environment (e.g., chamber walls and other equipment) to prevent mechanical, electrical, and thermal shortcutting.

With advances in electron microscopy, 3-D reconstruction software, and computational power, it has become possible to undertake precise imaging and reconstruction of objects on the order of 100 nm size and below. Areas of particular interest include biology (including studies related to viruses such as the novel coronavirus) and materials science where nanotechnology continues to develop new structures and new compositions. For high resolution, it can be desirable to minimize sample vibration. At the same time, as the size of sample particles grows, so too does the number of required images and consequently the amount of time to perform one study. In both cases, the sample stability required for accurate reconstruction becomes more stringent and can be addressed by cooling the sample to cryogenic temperatures to reduce atomic motion and to reduce radiation damage that can occur in a sample after long imaging times used for ultra-high resolution. Conventional technologies with liquid nitrogen or liquid helium reservoirs suffer from vibration induced by boiling liquid. Accordingly, there is a vital need to maintain stable cold temperatures as low as 77 K, 35 K, 20 K, or even lower, free of external vibrations, for 6 hours, 12 hours, or more. The connection cable taught herein enables the provision of cryogenic temperatures to samples on a stage without associated vibrations or mechanical disturbances by mechanically decoupling the reservoir from the stage and by using a braid that dampens vibrational motion of the cable itself. For example, the connection cable taught herein can form part of a cold chain from a solid thermal reservoir of the type described in U.S. Application Publication No. 2022/0404247, published December 22, 2022.

As used herein, "about" in relation to dimensions includes measures that are within 10% of the stated measurement value.

As used herein, "ultra-high vacuum" indicates an environment that has an ambient pressure of 1x10⁻⁸ mbar or lower. Maintenance of ultra-high vacuum within a chamber is confounded by real or virtual leaks that prevent the pump from decreasing below a threshold value at which the rate of removal of gas or contaminants by the pump equals the rate of introduction of gas or contaminants by the real or virtual leak. A virtual leak is a source of gas or contamination that is physically trapped in a volume within the chamber with only a low conductance path between the volume and the chamber proper. To achieve ultra-high vacuum conditions, components within the chamber should be free of contaminants (by thorough cleaning) and/or virtual leaks (by ensuring that any trapped volumes within the component are accessible by high conductance paths so that they can be evacuated swiftly). The connection cable taught herein is suitable for use in ultra-high vacuum environments.

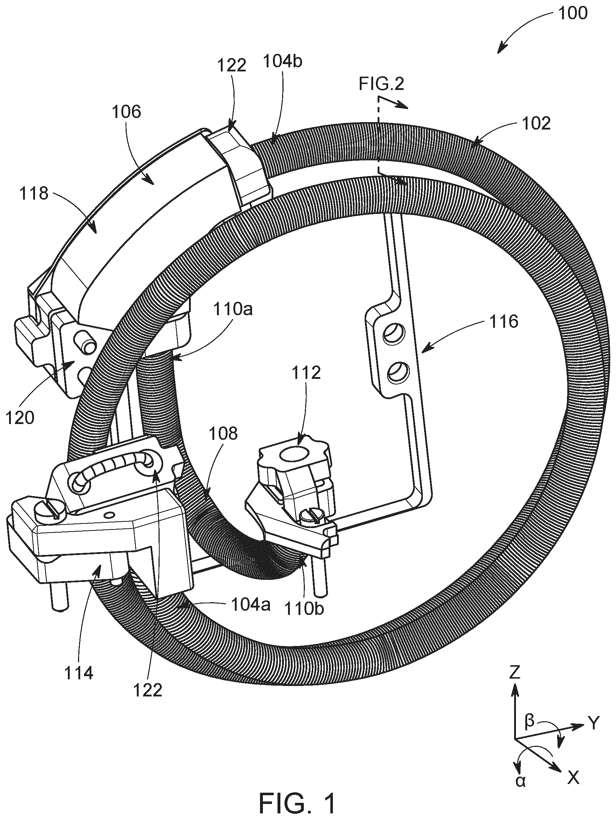

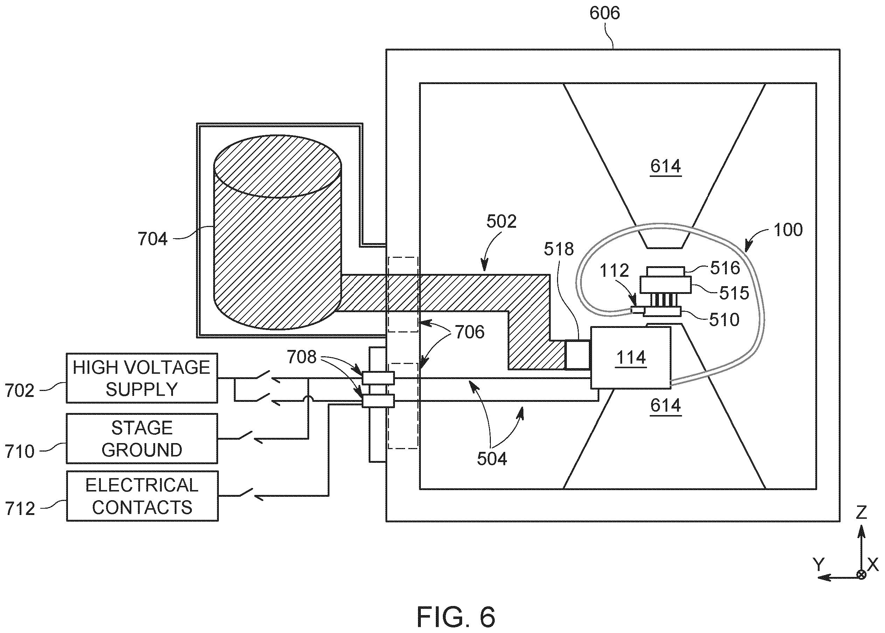

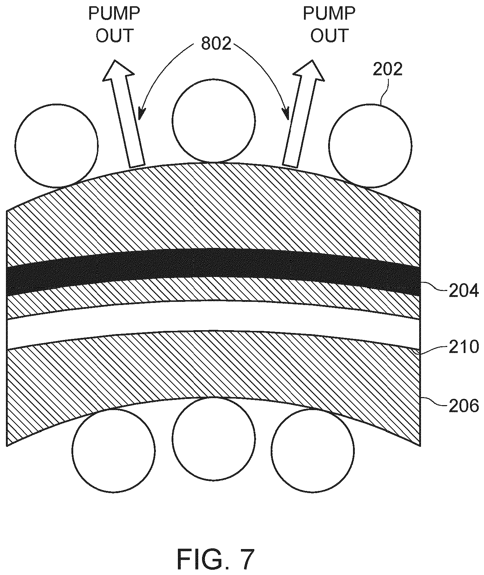

FIG. 1 illustrates a schematic of a connection cable 100 for operation in an ultra-high vacuum environment in accordance with various examples taught herein. The connection cable 100 includes a first section 102 and a second section 108 connected at an intermediate fixation 106. The connection cable 100 conducts thermal energy and electrical energy from a sample interface connector 112 to an external interface connector 114. The sample interface connector 112 mounts to a stage that holds the sample or holds a cartridge including the sample (as described and shown in greater detail below with respect to FIG. 6). The external interface connector 114 supplies cryogenic temperatures (e.g., via a heat sink) and electrical power that are sourced from outside a vacuum chamber to the connection cable 100. The connection cable 100 provides a mechanical connection between the external interface connector 114 and the sample interface connector 112 while still allowing the stage to translate, tilt, and rotate in five dimensions. The connection cable 100 is constructed such that virtual leaks within the connection cable 100 are mitigated as described in greater detail below with respect to FIG. 7.

In some examples, the first section 102 of the connection cable 100 forms a helix shape. A cylindrical component of the helix can be oriented in the y-z plane (as shown in FIG. 1) while a longitudinal component is oriented in an x-axis direction. The first section 102 is oriented to route electrical and thermal connections from the exterior of the vacuum chamber to the sample or stage without contacting other elements within the vacuum chamber. In charged particle microscope instruments, the volume inside the vacuum chamber and particularly in the vicinity of the stage is limited because the sizable charged-particle optics (such as electromagnetic coils) to manipulate the charged particle beam should be placed close to the stage to improve imaging quality and reduce aberration. At the same time, contact is to be avoided between thermal conductors or electrical conductors and other elements (such as coils or chamber walls) is to be avoided to avoid electrical and thermal leakage, to improve safety (e.g., avoiding high voltage, short circuiting, or low temperatures) on chamber walls and system components, and to better isolate the stage from the environment. The arrangement of the first section 102 into a stiff but bendable shape (such as a helix) helps prevent contact between the connection cable 100 and other systems elements while also enabling motion in the three translation directions and at least one rotational direction (e.g., α-angle rotation about the x-axis). In some examples, the first section 102 passes through an angular range in the x-y plane of about 630 degrees.

The second section 108 of the connection cable 100 can have a U- or bent shape. In some examples, the second section 108 can extend generally along the same direction as a longitudinal component defined by the helix of the first section 102 (e.g., the x-direction). In some examples, the second section 108 extends generally along an orthogonal direction with respect to the shape of the first section 102. The shape of the second section 108 can enable continuous electrical and thermal contact between the stage or sample and the external environment during stage motion along at least a second rotational direction (e.g., β-angle rotation about the y-axis). The use of a first section 102 and a second section 108 that are generally oriented orthogonal to one other enables the connection cable 100 to comply with motion in multiple directions while also maintaining an acceptable bend radius at all points within the connection cable and without blocking the charged particle beam.

The intermediate fixation 106 provides a stable mount point for the second end 104b of the first section 102 and the first end 110a of the second section 108. In some examples, the intermediate fixation 106 can comprise a housing 118, one or more cable mounts 122, and fasteners 120 to secure the intermediate fixation 106 to a mounting plate 116 or other element in the vacuum chamber of a charged particle microscope.

The mounting plate 116 can connect at least a portion of the connection cable 100 to a base for the stage or to another sturdy fixation point within the charged particle microscope that provides translational and rotational motion. In some examples, the intermediate fixation 106 attaches to the mounting plate 116.

While the example connection cable 100 of FIG. 1 includes a separated first section 102 and second section 108 that are oriented generally orthogonal to one another, connection cables 100 as taught herein are not so limited. For example, one skilled in the art appreciates that the scope of the present disclosure encompasses a connection cable 100 having a single continuous section that extends between connectors or can include more than two segments that are connected to one another through connectors or intermediate fixations 106.

In some examples, the connection cable 100 taught herein can be supplied or manufactured as only the elongated cable-like elements such as the first section 102 and second section 108. In other words, elements such as the sample interface connector 112, external interface connector 114, and intermediate fixation 106 can be supplied separately or preinstalled into a charged particle microscope such that the supplied or manufactured connection cable 100 can be installed into the charged particle microscope by attachment to pre-existing fixtures and connections. In other examples, the connection cable 100 taught herein can be supplied or manufactured such that one or more of the sample interface connector 112, external interface connector 114, or intermediate fixation 106 are pre-connected to the first section 102 or second section 108. In such examples, the connection cable 100 including connectors (sample interface connector 112, external interface connector 114) or fixation elements (intermediate fixation 106) can be installed into an existing charged particle microscope.

In some examples, a total length of the first section 102, intermediate fixation 106, and second section 108 of the connection cable 100 is in a range from 200 mm to 500 mm, in a range from 300 mm to 400 mm, or about 360 mm.

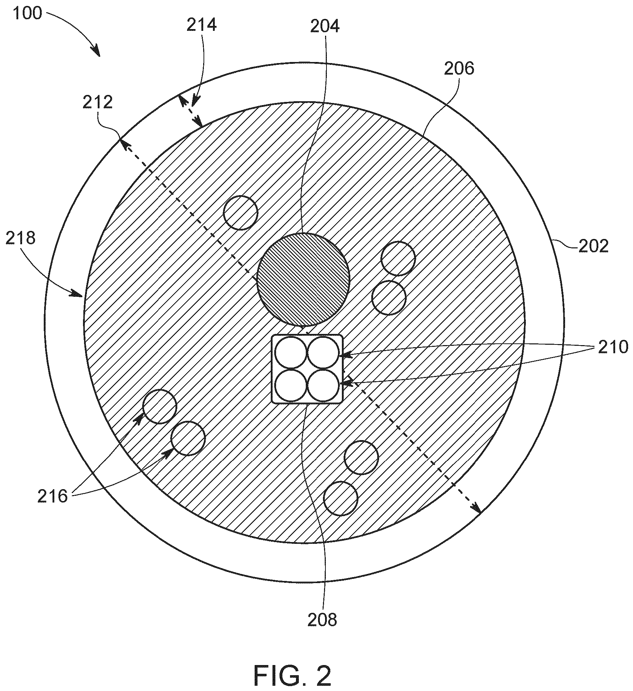

FIG. 2 illustrates a cross-sectional view through a section of the connection cable 100 taken, for example, at the location illustrated in FIG. 1. The connection cable 100 includes an inner structural element 204, one or more braids 206, and one or more electrical conductors 210 contained at least in part within an outer spring 202. The braid 206 can ensure good thermal connection between the sample or stage at the sample interface connector 112 and the external interface connector 114. The electrical conductors 210 provide electrical contacts between the stage or sample (via the sample interface connector 112) and external devices such as voltage supplies or electrical testing or probe circuitry (via the external interface connector 114). The inner structural element 204 is stiff enough to maintain the relevant section of the connection cable 100 in a substantially uniform shape while the outer spring 202 surrounds and contains components of the connection cable 100 in a single bundle.

In various examples taught herein, the connection cable 100 can include one electrical conductor 210 or multiple electrical conductors 210 such as two, three, four, or more electrical conductors 210. For example, the use of four electrical conductors 210 can enable four-point temperature measurements to read-out a temperature sensor or to determine the exact power being dissipated inside the sample by a heater without sensitivity to electrical resistance within the electrical conductors 210 themselves. In other examples, a single electrical conductor can provide an electrical potential at the sample if another component in the charged particle microscope (e.g., the stage) is grounded. In some examples, the electrical conductors 210 are surrounded by insulation 208 to prevent contact between a conductive portion of the electrical conductor 210 and the braid 206. In examples with multiple electrical conductors 210, the electrical conductors 210 can be collectively wrapped and bundled together in one or more layers of the insulation 208, each electrical conductor 210 can be wrapped individually in one or more layers of the insulation 208, or both individual and collective insulation 208 wrapping layers can be used. When individual insulation 208 is used, improved vacuum pumpability of the cable 100 and limited motion hysteresis can result. In some examples, the insulation 208 can include one or more electrically insulating materials such as a polyimide film (e.g., Kapton^{™} film). The conductive portion of the electrical conductor 210 can include copper or other conductive materials. In some examples, a diameter of the conductive portion of the electrical conductor 210 can be in a range from 0.05 to 0.25 mm, in a range from 0.1 to 0.2 mm, or about 0.16 mm. The conductive portion of the electrical conductor 210 can be sized as 34 American wire gauge (34 AWG) in some examples. In other examples, the conductive portion of the electrical conductor 210 can be other diameters. In some examples, the electrical conductors 210 are rated to carry 5 V signals with 200 mA current per conductor.

The braid 206 is configured to create a channel of high thermal conductance between the sample or stage and a heat-controlling element (e.g., heat sink) or device located distantly from the sample or stage. The heat-controlling element is generally located external to the vacuum chamber. The braid 206 is also configured to connect (via the external interface connector 114) to a high voltage supply external to the vacuum chamber and to carry high voltage to the stage (via the sample interface connector 112). In some examples, the braid 206 is made up of many individual conductive elements 216 or smaller braids 206 that are bundled together and contained within the outer spring 202. The individual conductive elements 216 can include or be made of a material with high thermal conductivity such as a variety of copper (for example, high purity, oxygen-free copper). In some examples, each individual conductive element 216 in the braid 206 can have a diameter in a range from 10 micrometers to 50 micrometers or a diameter of about 25 micrometers. In some examples, the braid 206 as a unit is formed collectively of between 5,000 to 15,000 individual conductive elements, between 5,000 to 10,000 individual conductive elements, or over 9,000 individual conductive elements. The individual conductive elements can be fixed to one another at ends of the connection cable 100 (such as by a cable mount as described below) but can be free to move with respect to one another throughout the bulk of the cable. By including a braid 206 formed of a large number of thin individual conductive elements such as thin copper wires, the connection cable 100 can be easily bent or manipulated into the desired shape and can move and bend during motion of the stage during imaging operations. In some examples, the braid 206 is suitable to be maintained at a temperature in a range from 10 Kelvin to 35 Kelvin, in a range from 25 to 35 Kelvin, in a range from 50 to 100 Kelvin, or in a range from 100 to 300 Kelvin. In some examples, the braid 206 can maintain the sample interface connector 112 (and, thereby, the sample or stage) at a temperature of 35 Kelvin or less. In some examples, the use of a number of small diameter individual conductive elements 216 improves vibrational damping of the cable in relation to the vibrational motion of a similarly sized single-piece conductor due to energy dissipation as individual conductive elements move against one another.

In some examples, an outer diameter 212 of the connection cable 100 (e.g., an outer diameter 212 of the first section 102 or the second section 108) can be in a range from 1 mm to 10 mm or in a range from 2 mm to 6 mm. In one example, the outer diameter 212 of the connection cable 100 is preferably 4 mm.

The inner structural element 204 can be formed of a solid wire, a hollow wire, or a spring in various examples. While the inner structural element 204 can be included in both the first section 102 and the second section 108 in some examples, other examples of the connection cable 100 include an inner structural element 204 only in the first section 102 with no inner structural element 204 in the second section 108. The inner structural element 204 can be bent into the desired three-dimensional shape to provide spatial routing for the first section 102 or second section 108 or, in some examples, for a single section that makes up the entire connection cable 100. A thickness of the inner structural element 204 can be selected to balance competing factors of allowing the relevant section of the connection cable 100 to easily be bent to accommodate stage motion in five degrees of freedom vs. ensuring that the overall shape of the relevant section of the connection cable remains stiff enough to retain its shape in space. The inner structural element 204 that maintains the stiffness and shape of the connection cable 100 is located within the bundle of components contained at least partially within the outer spring 202. In some examples, the inner structural element 204 is contained at least partially within the braid 206. By placing the inner structural element 204 within the bundle, the inner structural element 204 can help retain the connection cable 100 in the correct shape and can help components within the bundle (e.g., electrical conductors 210 and braid 206) retain their relative positions. The inner structural element 204 can variously retain its shape either while held under tension or naturally as a result of its internal structural properties.

In various examples, the inner structural element 204 has a diameter in a range from 0.5 mm to 2.0 mm or a diameter of about 1 mm. In some examples, the inner structural element 204 is formed of or includes titanium or other non-magnetic materials. In some examples, the material, shape, or length of the inner structural element 204 is selected to critically damp vibrational motions within the connection cable 100. By critically damping vibrational motion of the connection cable 100, impulses from the external environment (such as mechanical vibrations) do not create long-period oscillations in the motion of the stage or sample caused by motion of the connection cable 100.

The outer spring 202 can be any suitable tension or expansion spring according to the needs of a particular application. The outer spring 202 encloses or contains other components in the connection cable 100 into a single bundle form and thus avoids the perils of using separately routed cables for each electrical and thermal connection. In some examples, the outer spring 202 can be an endless tension spring or endless extension spring wherein the spring has no terminating elements at the ends such as an eyelet or loop. The outer spring 202 can be made of or include any suitable material with appropriate flexibility, electrical conductivity, and non-magnetic or non-magnetizable properties. Electrical conductivity in the outer spring 202 prevents charging effects due to deposition of charged particles from the charged particle system, and non-magnetic or non-magnetizable properties allow the outer spring 202 to avoid interference with the motion of charged particles in the chamber. For example, the outer spring 202 can include titanium or phosphor bronze. The outer spring 202 can include an outer coating to increase the thermal radiation reflectivity (i.e., lower the emissivity) of the outer spring 202. For example, the outer spring 202 can be coated with gold in some examples.

In some examples, one or more of the inner structural element 204, the electrical conductors 210, and the braid 206 are contained within the outer spring 202 along substantially the entire length of the connection cable 100. In other examples, the outer spring 202 only encloses and contains components in the connection cable 100 over a section of the cable 100 such as, for example, only the first section 102 or only the second section 108.

The outer spring 202 includes an outer portion (such as a coil) with a lumen 218 or cavity extending therethrough. The electrical conductor 210, braid 206, and inner structural element 204 at least partially pass through this cavity or lumen 218 and are contained within the connection cable 100. Specifically, while the electrical conductor 210, braid 206, and inner structural element 204 can pass through the lumen 218, there may be portions of the electrical conductor 210, braid 206, and inner structural element 204 that extend beyond the outer spring 202 such as within the intermediate fixation 106 as described further below.

The outer spring 202 stretches and bends to allow for bending of the connection cable 100. When the connection cable 100 bends (such as the helical bend of the first section 102 or the U-shaped bend of the second section 108 described above), segments of the coil in the outer spring 202 spread apart from one another on the outer diameter 212 of the connection cable 100 to create gaps as described in greater detail below with respect to FIG. 7. The gaps that form in the outer spring 202 can allow gas trapped within the connection cable 100 to be evacuated from within the lumen 218 or cavity of the connection cable 100 to the outside of the connection cable 100 so that the vacuum chamber can attain ultra-high vacuum conditions. In some examples, a spring thickness 214 of the outer spring 202 can be in a range from 0.1 to 0.5 mm, in a range from 0.1 to 0.3 mm, or about 0.2 mm.

The braid 206, outer spring 202, or both braid 206 and outer spring 202 can magnetically shield the electrical conductors 210 in some examples. By burying the electrical conductors 210 within the braid 206 which is set within the outer spring 202, electromagnetic fields that are induced by current flow in the electrical conductors 210 is shielded by the braid 206 or outer spring 202 so that the electromagnetic fields do not enter the vacuum chamber and disrupt the flow of charged particles in the charged particle system. Additionally, burying the electrical conductors 210 within the braid 206 also prevents charge build-up onto the insulator 208 that surrounds the electrical conductors 210.

In some examples, a majority of a cross-sectional area of the connection cable 100 is dedicated to the braid 206. In some examples, the available cross-sectional area for the braid 206 is in a range from 4 mm² to 8 mm². In some examples, the connection cable 100 includes no magnetic materials. As magnetic materials can divert the flight path of charged particles, the exclusion of magnetic materials from the connection cable 100 can be beneficial to avoid disturbing the charged particle beam used for imaging or other processes such as milling.

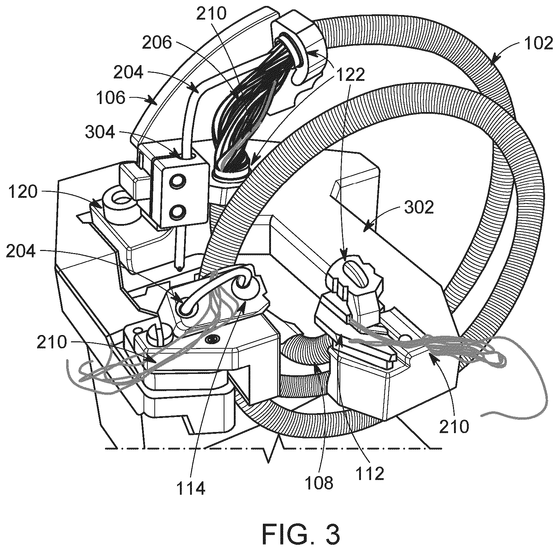

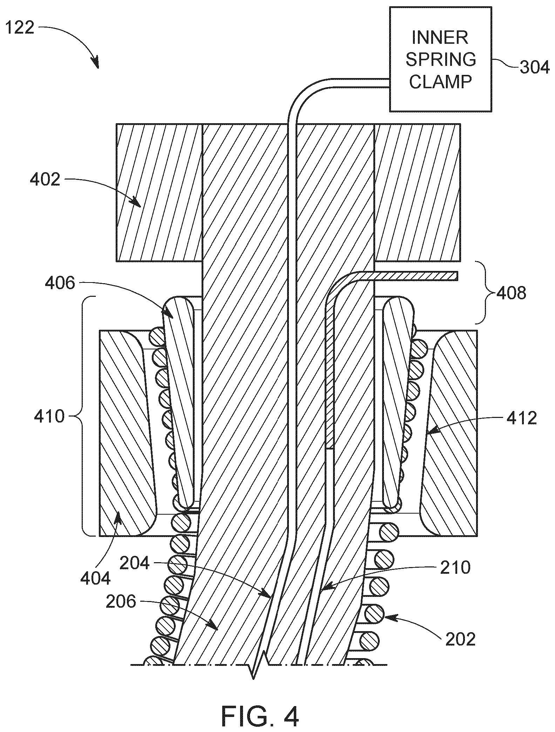

In some examples, the stiffness of the first section 102 of the connection cable 100 is less than 1x10⁻⁴ N/m. The inner structural element 204 can contribute a majority portion of the stiffness of the cable, but other factors such as the fill factor of the braid 206 within the lumen 218 can contribute. In some examples, the stiffness of the first section 102 can dictate a maximum deviation of the position of the first section 102 from a nominal position due to gravitational force on the first section 102. In these examples, parameters of the inner structural element 204 can be selected to provide sufficient support to maintain the position of the first section while avoiding increased stress on the inner structural element 204 that can lead to lifetime degradation issues. For example, the maximum deviation of the position of the first section 102 can be less than 1.5 mm, less than 1.0 mm, or in a range from 0.4 to 0.8 mm. FIG. 3 illustrates a view of a connection cable 100 mounted to a jig 302 and shows an interior of the intermediate fixation 106 of the connection cable 100 in accordance with some examples taught herein. In the view of FIG. 3, the housing 118 of the intermediate fixation 106 is removed. The braid 206 passes from the first section 102 to the cable mount 122, enters an open area, and then enters another cable mount 122 that routes the braid 206 into the second section 108. The electrical conductors 210 are located outside of the bundle of individual conducting elements in the braid 206 in the open section as described in greater detail below with respect to FIG. 4. The electrical conductors 210 are also seen extending out of the first end 104a of the first section 102 (i.e., at the external interface connector 114) and out of the second end 110b of the second section 108 (i.e., at the sample interface connector 112).

As the inner structural element 204 exits the first section 102, the inner structural element 204 is located outside of the bundle of individual conducting elements in the braid 206. The inner structural element 204 is clamped at an inner structural element clamp 304 to create axial fixation and generate tension in the inner structural element 204. Once clamped, the inner structural element 204 can more effectively hold its shape. The inner structural element clamp 304 can be, for example, a vise or groove that can generate compressive force from motion of associated screws or bolts. In other examples, the inner structural element clamp 304 can include a set screw that pins the inner structural element 204 against a flat or grooved surface. The use of a set screw can create a more consistent clamping force over the operating temperature range and can reduce issues with meeting manufacturing tolerances. In some examples, the inner structural element clamp 304 can include preloading the inner structural element 204 into a hole alone or in combination with set screws or bolts to mechanically fix the inner structural element 204.

FIG. 4 illustrates a cable mount 122 to mount an end (e.g., first end 104a, second end 104b, first end 110a, second end 110b) of a section (e.g., first section 102 or second section 108) of the connection cable 100 in some examples. The cable mount 122 can be located at one or more of the intermediate fixation 106, the external interface connector 114, the sample interface connector 112 in an example connection cable 100 setup. The cable mount 122 preferably does not use chemical adhesives or glues to create fixation of components of the connection cable 100 to avoid introducing fouling agents or virtual leaks that could compromise high-vacuum level within a vacuum chamber.

The cable mount 122 includes a braid clamp 402 and an outer spring clamp 410. The outer spring clamp 410 includes a collar 404 and an insert 406. The insert 406 can have a wedge shape that is complementary to an inner surface 412 of the collar 404. As the outer spring is driven into the outer spring clamp 410, the wedge shape of the insert 406 forces the outer spring 202 to spread radially outward at the collar to increase an interior volume within the outer spring 202 at the outer spring clamp 410. This larger volume can ease insertion of the braid 206, electrical conductors 210, and inner structural element 204 during manufacture of the connection cable 100. The outer spring clamp 410 maintains tension on an end of the outer spring 202 to hold the end in place and to ensure that the outer spring 202 shields the braid 206 along the entire length of the connection cable 100.

The braid clamp 402 tightly clamps the individual conducting elements in the braid 206 to increase contact between the braid clamp 402 and the braid 206 and to reduce electrical and thermal resistance at the interface. Thermal and/or high voltage electrical connection can be made to the braid 206 through the braid clamp 402. The braid clamp 402 can include a vise or split ring wherein compressive force is applied by an associated screw in some examples. In arrangements where the braid 206 does not terminate at the cable mount 122 (e.g., within the intermediate fixation 106), the braid clamp 402 may not be present as part of the cable mount 122.

In some examples, a gap 408 is formed between the braid clamp 402 and the outer spring clamp 410. In the gap 408, the electrical conductor 210 can be brought out from inside the braid 206 and can be routed to a terminal or contact to connect to the stage (e.g., at the sample interface connector 112) or to external electrical equipment such as sources or sensors (e.g., at the external interface connector 114). In other examples, the electrical conductor 210 is simply routed externally to the braid clamp 402 to avoid being crushed under the clamping pressure of the braid clamp 402. For example, the electrical conductor 210 can be routed out of the braid 206 at a gap 408 in a first cable mount 122 in the intermediate fixation 106 (e.g., exiting the first section 102) and then routed back into the braid 206 at a gap 408 in a second cable mount 122 in the intermediate fixation 106 (e.g., to enter the second section 108).

For sections of the connection cable 100 that do not have an inner structural element 204, the cable mount 122 does not include an inner structural element clamp 304. For sections of the connection cable 100 that do not include an outer spring 202, the cable mount 122 can omit the outer spring clamp 410. At some junctions (such as the where first end 110a of the second section 108 feeds into the intermediate fixation 106, the cable mount 122 can allow the braid 206 and/or electrical conductors 210 to pass through without fixation.

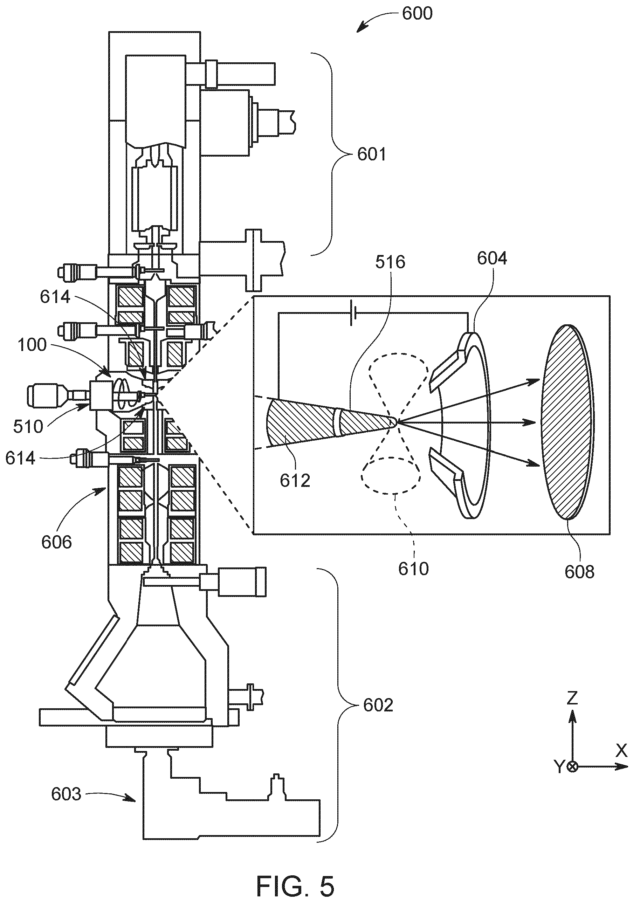

FIG. 5 illustrates a schematic view of the connection cable 100 as taught herein within an example charged particle system 600. In this example, the charged particle system 600 is configured to perform both atom probe tomography (APT) and transmission electron microscopy (TEM) on the sample 516. Example charged particle systems 600 compatible with the connection cable 100 as taught herein can also execute alternative or additional imaging modalities including, without limitation, x-ray energy dispersive spectroscopy (EDS) or electron energy loss spectroscopy (EELS). In some examples, the beam of charged particles in the charged particle system 600 can be used for machining operations such as in a focused ion beam (FIB) system.

The charged particle system 600 can include a vacuum chamber 606 that connects a charged particle source section 601, a stage 510, the connection cable 100, an imaging section 602, an EELS spectrometer 603, a counter-electrode 604, and a detector 608. The stage 510 can connect to a sample support 612 (such as a silicon or metal post) that supports a sample 516. The charged particle source section 601 produces a beam of charged particles that interact with the sample 516. Charged particles that are scattered, reflected, attenuated, or emitted by the interaction of the beam with the sample 516 are focused, imaged, and/or received in the imaging section 602 to produce a signal typical of charged particle microscopes such as TEMs. In the particular instance of EELS, the EELS spectrometer 603 can receive the post-sample charged particles to produce an EELS signal.

To perform an APT process, the charged particle system 600 applies a continuous or pulsed high voltage to the sample 516 via the connection cable 100 (including braids 206, outer spring 202, and/or electrical conductors 210) as described in relation to FIG. 5. The electric field induced at the sample 516 is sufficient to evaporate ions from the specimen surface that are then accelerated by the counter-electrode 604 until the ions finally impinge on the detector 608. In some examples, evaporation of the ions can be controlled by application of pulses of energy from a laser 610. In some cases, individual ions can be evaporated and accelerated onto the detector 608. The time of flight of the ions from the sample 516 to the detector 608 allows identification of the ion species across a range of ion masses. Notable, the APT process is capable of identifying light elements, which is of particular interest to assess dopant distributions in semiconductor devices.

The charged particle system 600 can perform APT processes in conjunction with other imaging processes, such as TEM, EDS, or EELS, so determine structural data describing the sample such as diffraction patterns, secondary electron emission data, sample thickness information, or the like. The charged particle system 600 can be used to perform methods that generate transmission electron microscopy images over a range of tilt-angles and/or positions, as an approach to reconstruction of three-dimensional information about the sample, through a process of atom and electron tomography. In the single platform of the charged particle system 600, imaging can switch between APT and EM modes of operation and can provide progressive 2D/3D information about a sample during an APT procedure using an electron microscope. Between APT measurements, electron microscopy examinations can be performed to document the evolution of the sample shape, size, structure, composition at multiple points in the APT procedure of evaporation of the sample. These translational and rotational motions happen in the vicinity of pole pieces 614 associated with the charged particle source section 601 and the imaging section 602 which heavily constrain available space. In some examples, the connection cable 100 as taught herein advantageously provides the electrical and thermal connections to the stage 510 to maintain the sample 516 at appropriate voltages and temperatures to conduct APT or atom tomography (TOMO) processes during translations and high-angle tilt rotations of the sample 516 while avoiding physical contact or interference with components (such as the pole pieces 614 or the counter-electrode 604) that are close to the sample 516 and to provide imaging capabilities. In some examples, the connection cable 100 applies high voltage only when the sample tilt in both directions is around zero degrees and the sample is located at around a focal point of the charged particle beam. Similarly, the connection cable 100 can only provide cooling when the sample is arranged at large tilt angles, e.g., during an APT or TOMO run. In other examples, the connection cable 100 can apply high voltage while the sample is arranged at tilt angles greater than zero.

FIG. 6 illustrates a schematic view of the electrical and thermal systems of the example charged particle system 600 including the connection cable 100 taught herein. For simplicity, the view of FIG. 6 shows only the portion of the vacuum chamber 606 in the vicinity of the pole pieces 614. The vacuum chamber 606 encloses the sample 516, stage 510, and connection cable 100. The connection cable 100 facilitates thermal connection between a cartridge 515 (and thereby to the sample 516) and an external reservoir 704. The external reservoir can be a solid thermal reservoir of the type described in U.S. Application Publication No. 2022/0404247, published December 22, 2022. The connection cable 100 facilitates electrical connection between the sample 516 and a high voltage supply 702 and between the sample 516 and electrical contacts 712 external to the vacuum chamber 606.

The reservoir 704 can be referred to as a heat sink in some applications or examples. In some examples, the reservoir 704 can be a Dewar flask that contains cooling fluid, e.g., liquid nitrogen or liquid helium. In other examples, the reservoir 704 can be a solid thermal reservoir of the type described in greater detail in U.S. Application Publication No. 2022/0404247, published December 22, 2022. In some examples, the reservoir 704 can provide cryogenic temperatures in a range of 10-50 K, 10-100 K, or 35-100 K or temperatures of about 77 K or 35 K to the stage 510. In some examples, stability of the temperature of the reservoir 704 can be maintained to a tolerance in a range from 10 mK to 3 K. In some examples, the reservoir 704 can be a heat pump that raises the temperature of the sample 516. The reservoir 704 is connected through a vacuum feedthrough 706 in a wall of the vacuum chamber 606 to a cooler interface 502. In some examples, the cooler interface 502 can be a cold finger. The cooler interface 502 connects to the external interface connector 114 through the high voltage isolator 518 and the mounting interface as described further below. The braid 206 of the connection cable 100 connects to the external interface connector 114 and carries thermal energy between the external interface connector 114 and the sample interface connector 112.

The high voltage supply 702 is configured to supply a voltage of up to 20 kV such as a voltage in a range from 5 kV to 20 kV in various examples. The high voltage supply 702 is connected through individual switches to a single port 708 or multiple ports 708 such as two ports. The ports 708 connect through a vacuum feedthrough 706 in a wall of the vacuum chamber 606 to an electrical interface 504. The electrical interface 504 carries the high voltage to the cable mount 122. The braid 206 in the connection cable 100 carries high voltage between the external interface connector 114 and the sample interface connector 112. In some examples, the high voltage supply 702 can provide the high voltage to induce evaporation of atoms of the sample 516 to perform an APT analysis as described above. The stage 510 is connected to a stage ground 710 external to the chamber. The high voltage isolator keeps the grounded stage 510 separated from the high voltage supplied by the connection cable 100 at the stage 510.

Electrical contacts 712 are configured to provide static or varying electrical voltages or currents to the sample 516 or the stage 510. In analysis workflows for some samples 516, such as for semiconductor chips or quantum computing studies, the sample 516 is provided with electrical signals during a charged particle analysis or in between analyses (i.e., in a "before- and-after" study). In some examples, the electrical conductors 210 can provide a current to a heater (such as a microelectromechanical system or MEMS heater) at or near the location of the stage 510 or sample 516 for localized heating of portions of the sample 516. In some examples, the electrical conductors 210 can carry signals from a sensor such as a temperature sensor located at or near the stage 510 or sample 516. Some use cases appropriate for use of the connection cable 100 include the situation where high voltage is applied to the sample during first analysis mode(s) (e.g., APT imaging) while other electrical signals are applied to the sample during second analysis mode(s) (e.g., readout of a temperature sensor or control of a heater near the sample). During the first analysis modes, the braid 206 and electrical conductors 210 are all collectively connected to the same high voltage potential to prevent electrical strikethrough (e.g., using the port(s) 708 and associated switches) the connection is made external to the vacuum chamber). During the second analysis modes, the braid 206 is disconnected from high voltage and is connected to ground potential to prevent electrical charge buildup from the charged particle beam. At the same time, the electrical conductors 210 can each independently carry electrical signals such as digital logic signals or sensor measurements.

The connection cable 100 as taught herein connects the stage 510 to the cooler interface 502 and the electrical interface 504. The stage 510 can include a main platform, a beta-tilt platform, and the cartridge 515 that can support the sample 516. In one example, the beta-tilt platform and cartridge 515 extend from a face of the main platform. The main platform can adjust the position of the cartridge 515 in real space in three translation directions (i.e., along x-, y-, and z-axis directions) as well as adjusting the tilt in the alpha-angle rotation direction (i.e., rotation about the x-axis). The beta-tilt platform can adjust the tilt of the cartridge 515 in the beta-angle rotation direction (i.e., rotation about the y-axis). Example stages 510 suitable for use with the connection cable 100 of the present disclosure are described in U.S. Patent 11,244,805, issued February 8, 2022.

The mounting plate 116 can connect to the face of the main platform in some embodiments. In this arrangement, the orientation of the first section 102 of the connection cable 100 (e.g., the x-y plane in which the helix of the connection cable 100 rotates axially) is maintained in relation to the cartridge 515. The first end 104a of the connection cable 100 can remain stationary while the cartridge 515 translates and rotates in space. The second end 104b of the first section 102 of the connection cable 100 does not translate with respect to the cartridge 515 during translational motion of the stage. The beta-tilt platform extends through the interior of the helix of the first section 102.

The stage 510 can translate in three dimensions and can tilt or rotate the sample 516 in at least two rotational directions. In some examples, the stage 510 can translate the sample 516 by a distance in a range from 0.5 mm to 4 mm in any of the x-axis, y-axis, or z-axis directions. The range can also be represented with respect to a center point (i.e., nominal position) such that the stage 510 can translate the sample 516 by a distance in a range from ± 0.25 mm to ± 2 mm with respect to the center point in any of the x-axis, y-axis, or z-axis directions. In one example, the stage 510 can translate the sample 516 by a distance of at least ± 1 mm with respect to a center point in any of the x-axis, y-axis, or z-axis directions. In some examples, the stage 510 can rotate the sample 516 in an alpha (α) angle tilt direction by an amount in a range from -90° to +90° with respect to a nominal center position. In some examples, the stage 510 can rotate the sample in a beta (β) angle tilt direction by an amount in a range from -10° to +10° with respect to a nominal center position. In some examples, the stage 510 includes a high voltage isolator backing the beta-tilt platform to isolate high voltage at the stage 510 and prevent dangerous voltages from being applied to or through the main platform or other components of the charged particle system or vacuum chamber.

The external interface connector 114 can connect the cooler interface 502 and the electrical interface 504 to the connection cable 100. The external interface connector 114 can include a high voltage isolator 518 between the braid 206 and the cooler interface 502. The high voltage isolator 518 prevents high voltage from reaching the cooler interface 502 (which may be electrically grounded in some instances) and/or the walls of the vacuum chamber. The high voltage isolator 518 can be formed of a material that has high thermal conductivity but poor electrical conductivity such as sapphire. The high voltage isolator 518 can connect to the external interface connector 114 through a mounting interface of the external interface.

The cooler interface 502 can conduct thermal energy between the external interface connector 114 and the sample interface connector 112 through the connection cable 100. In some examples, the cooler interface 502 can connect a cryogenic reservoir 704 (such as a liquid helium dewar) that is outside the vacuum chamber to the external interface connector 114.

The electrical interface 504 can include electrical connection plates, external connectors, and one or more wires, ribbons, or other electrical conductors that connect power supplies, sensors, or other digital or analog electronics external to the vacuum chamber to the external interface connector 114. For example, the electrical interface 504 can include pins from the electrical (vacuum) feedthrough, a flex foil that connects to the external interface connector 114, and a plate or connector that electrically connects the pins to the flex foil. The electrical interface 504 can spatially isolate individual wires to prevent discharge between wires.

FIG. 7 illustrates a schematic view of a longitudinal cross section of a portion of the connection cable 100 that shows pump-out of the connection cable 100. In FIG. 7, the portion of the connection cable 100 is bent such as would occur in the first section 102 (e.g., helical bend) or second section 108 (e.g., U-shaped bend) as described above. When the connection cable 100 bends, individual windings of the outer spring 202 become spaced apart from one other on a lateral surface of the outer spring 202 (e.g., at an outer diameter of the bend) of the connection cable 100. The spacing of individual windings introduces vacuum conductance paths 802 between the windings along the lateral surface. These vacuum conductance paths 802 advantageously enable the pump-out of the interior of the connection cable 100 (i.e., the inner volume or lumen 218 within the outer spring 202).

Placement of vacuum conductance paths 802 along the lateral surface of the connection cable 100 provides an advantage over conventional cables that are sealed along the lateral surface. The interiors of such conventional cables are pumped out from the ends of the cable, but conductance from the midpoint of the cable to the ends of the cable (i.e., along the length of the cable) is very poor. As such, the interiors of conventional cables act as virtual leaks. The present connection cables 100 avoid these difficulties by providing numerous vacuum conductance paths 802 through the lateral surface along the length of the cable.

In ultra-high vacuum systems such as charged particle systems 600, the vacuum level of one or more portions of the system is maintained in a range of 1x10⁻⁸ mbar to 1x10⁻¹¹ mbar. For example, the vacuum level can be maintained at or below 5x10⁻¹⁰ mbar. At such high vacuum levels (i.e., low pressures), outgassing from components within the chamber becomes an important factor that determines how high of a pressure can be achieved. In many conventional components, residual gas molecules within an outer casing of the component can slowly leak through the casing or out of small holes in the casing over a long period of time. In other words, the time needed to fully pump residual gas out of the component and, thus, the vacuum chamber 606 is greatly extended because the residual gas will only slowly leave the interior of the component. The connection cable 100 as taught herein overcomes this issue by creating vacuum conductance paths 802 in the outer spring 202. The vacuum conductance paths 802 are large enough to facilitate escape of residual gas molecules from within the interior volume or lumen 218 of the outer spring 202 of the connection cable 100.

In typical experiments, the connection cable 100 including outer spring 202 and braid 206 can be held at high voltage, e.g., 15 kV. During motion of the stage 510, there is a risk that the high voltage could discharge if the connection cable 100 approaches too closely to electrically grounded portions of the stage 510, the vacuum chamber 606, or pole pieces 614. Similarly, contact between portions of the outer spring 202 of the connection cable 100 and the stage 510, vacuum chamber 606, the pole pieces 614, or even other portions of the connection cable 100 itself can cause thermal leaks that can damage equipment and lead to loss of cryogenic temperatures at the sample 516. Cables and methods described herein provide sufficient clearance at all possible combinations of stage tilt and translation to avoid high voltage discharge and thermal leaks between the outer spring 202 and surroundings. In some examples, the connection cable 100 applies high voltage only when the sample tilt in both directions is around zero degrees and the sample is located at around a focal point of the charged particle beam. Similarly, the connection cable 100 can only provide cooling when the sample is arranged at large tilt angles, e.g., during an APT or TOMO run. In other examples, the connection cable 100 can apply high voltage while the sample is arranged at tilt angles greater than zero.

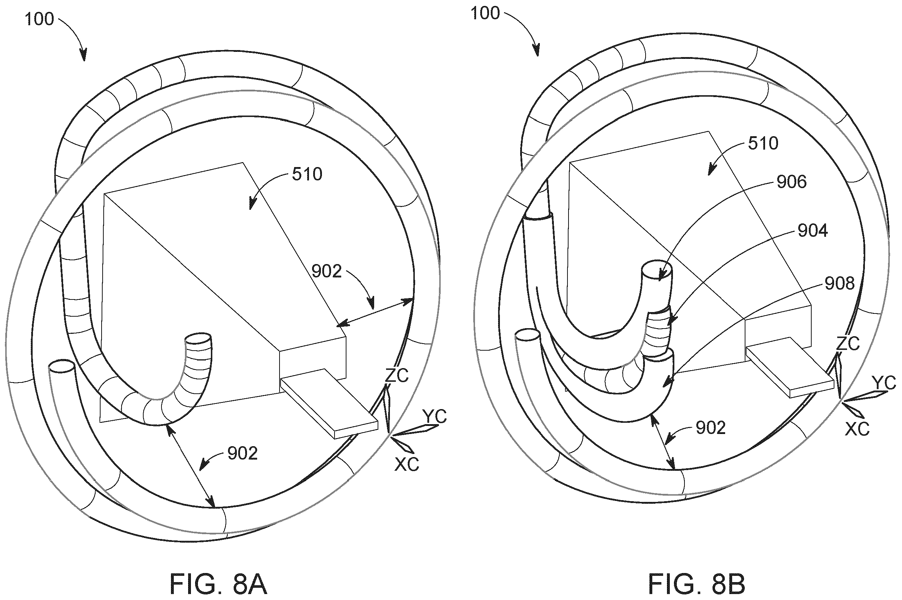

FIG. 8A illustrates a perspective view of the connection cable 100 connected to the stage 510 in a neutral tilt position. In the neutral position, the stage 510 has an alpha-angle tilt of about 0° and a beta-angle tilt of about 0°. The first section 102 of the connection cable 100 winds around the stage 510 and has nominal values for standoff distances 902 between all points on the connection cable 100 (e.g., points on outer spring 202 of the connection cable 100) and the nearby stage 510. In some examples, the minimum value of the closest standoff distance 902 between the connection cable 100 and other components of the system, such as the stage 510, is greater than 0 mm, is in a range from 0 mm to 10 mm, or in a range from 2.5 mm to 10 mm. In some examples, the minimum value of the closest standoff distance 902 is around 2.5 mm when the connection cable 100 is in a neutral position (i.e., alpha and beta tilts of nearly 0 degrees). In these examples, the standoff distance 902 between the connection cable 100 and the stage 510 can reduce below 2.5 mm during tilt operations if the high voltage is not applied but still remain greater than 0 mm to prevent thermal contact between the cable and the stage (or other elements within the chamber such as pole pieces). In some examples, one-half of a diameter of the helix formed by the first section 102 is no less than a distance of greater than 0 mm, a distance in the range of 0 to 10 mm, or a distance in the range of 2.5 mm to 10 mm.

FIG. 8B illustrates the same connection cable 100 connected to the stage 510 as in FIG. 8A wherein the view of the connection cable 100 is overlaid in three tilt states: nominal beta-tilt 904, negative beta-tilt 906, and positive beta-tilt 908. For the negative beta-tilt 906 state, the stage 510 is tilted at a beta-angle of -10° in this example. For the positive beta-tilt 908 state, the stage 510 is tilted at a beta-angle of +10° in this example.

As the stage 510 tilts in the beta-angle direction, portions of the second section 108 maintain a standoff distance 902 from the helical spatial path of the first section 102. The shape of the second section 108 (including, in some examples, the U-shaped bend) provides enough slack to enable the stage 510 to beta-tilt without pulling the second section 108 taut. At the same time, the second section 108 does not droop excessively such that the second section 108 is in danger of contacting the first section 102 at large negative beta-tilt values.

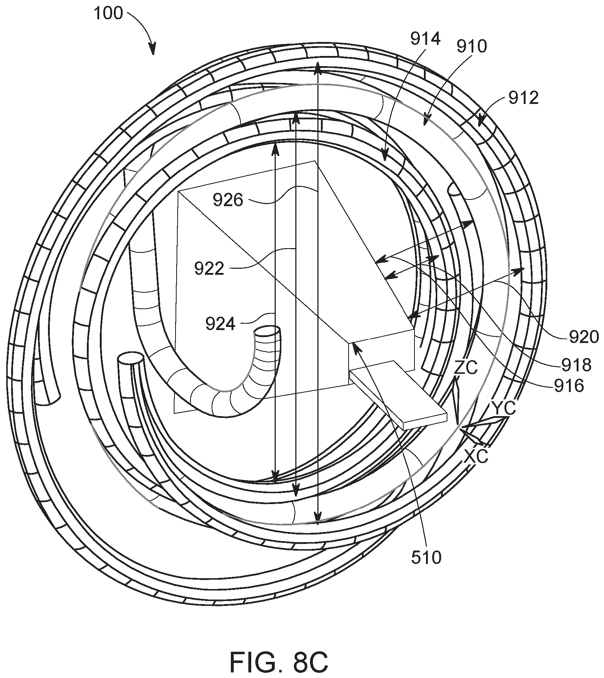

FIG. 8C illustrates the same connection cable 100 connected to the stage 510 as in FIG. 8A and FIG. 8B wherein the view of the connection cable 100 is overlaid in three tilt states: nominal alpha-tilt 910, negative alpha-tilt 912, and positive alpha-tilt 914. For the negative alpha-tilt 912 state, the stage 510 is tilted at an alpha-angle of -90° in this example. For the positive alpha-tilt 914 state, the stage 510 is tilted at an alpha-angle of +90° in this example.

The second end 110b of the second section 108 is connected to the stage 510 (through the sample interface connector 112) as the stage rotates. At the same time, the other end of the connection cable 100, i.e., the first end 104a of the first section 102, remains fixed in space and attached to the external interface connector 114. As a result of the motion of the second end 104b of the first section 102 of the connection cable 100 during rotation, the rotation of the stage has the effect of "winding" or "unwinding" the helical shape of the cable (provided primarily by the inner structural element 204).

In the nominal alpha-tilt 910 state, the first section 102 has a nominal standoff distance 916 from the stage 510. During tilt operations to positive alpha-angles, the first section 102 begins to "wind" from a nominal diameter 922 of the helix to a reduced diameter 924 of the helix, and the nominal standoff distance 916 reduces to a smaller reduced standoff distance 918. Nevertheless, even at extreme alpha-rotation values (such as +90°), the reduced standoff distance 918 between the connection cable 100 and any nearby objects (such as the stage 510, other portions of the connection cable 100, pole pieces 614, or walls of the vacuum chamber 606) is sufficiently large as to avoid thermal or electrical leakage between the connection cable 100 and these other objects. At the same time, the connection cable 100 is configured to follow a spatial routing path that avoids entangling the connection cable 100 with itself or other objects. In some examples, the minimum value of the reduced standoff distance 918 between the connection cable 100 and other components of the system, such as the stage 510, is in a range from 2.5 mm to 10 mm. In some examples, one-half of the diameter of the helix formed by the first section 102 (e.g., the nominal diameter 922, reduced diameter 924, or increased diameter 926) is no less than a distance of greater than 0 mm, a distance in the range of 0 mm to 10 mm, or a distance in the range of 2.5 mm to 10 mm.

The inner structural element 204 of the connection cable 100 is resilient enough to recover the original shape of the connection cable 100 when the stage 510 is rotated from the positive alpha-tilt 914 state to the nominal alpha-tilt 910 state. When the stage 510 performs a tilt to negative alpha-angles, the first section 102 begins to "unwind" from the nominal diameter 922 of the helix to an increased diameter 926 of the helix. At the same time, the nominal standoff distance 916 with respect to the stage 510 increases to a larger, increased standoff distance 920 with respect to the stage 510. However, the closest standoff distance 902 does not increase by such a large degree that the connection cable 100 threatens to connect with the walls of the vacuum chamber 606 or the pole pieces 614. In some examples, the increased diameter 926 of the helical portion of the connection cable 100 is in a range from 50-70 mm, or about 60 mm.

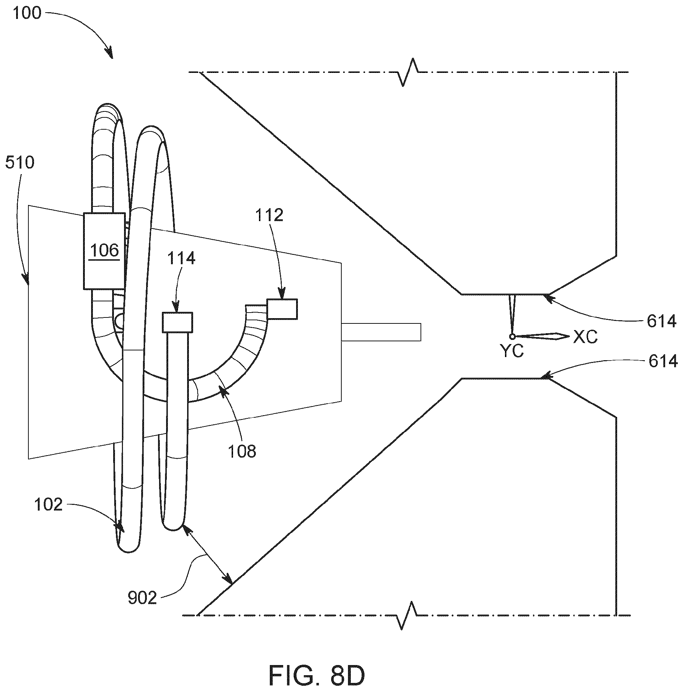

FIG. 8D illustrate a side view of the connection cable 100 in the negative alpha-tilt 912 state as also seen in perspective in FIG. 8C. The connection cable 100 has an increased diameter 926 of the helical portion (i.e., the first section 102) in this stage with accompanying increased standoff distance 920 from the stage 510. However, as the standoff distance from cable to stage grows during negative alpha-angle rotation, the standoff distance 902 from the first section 102 of the connection cable 100 to the pole pieces 614 decreases. In preferred examples of the connection cable 100 taught herein, the spatial routing (including, for example, shape and dimensions) of the connection cable 100 are selected (for example, by appropriate tension or shape of the inner structural element 204) such that the connection cable 100 will maintain the standoff distance 902 between the cable and all environmental surroundings (pole pieces, chamber, stage) of at least 0 mm, of at least 2.5 mm or, more preferably, at least 5 mm while still enabling translation in 3 dimensions (e.g., at least 2 mm total travel in each dimension), rotation through at least 180 total degrees in one rotational dimension, and rotation through at least 20 total degrees in a second rotational dimension. Thus, the geometric parameters of the connection cable in some examples are chosen to balance between maintaining standoff distance 902 to the stage 510 at one extreme of alpha-angle tilt and maintaining standoff distance 902 to the other elements (e.g., pole piece 614) at the other extreme of alpha-angle tilt.

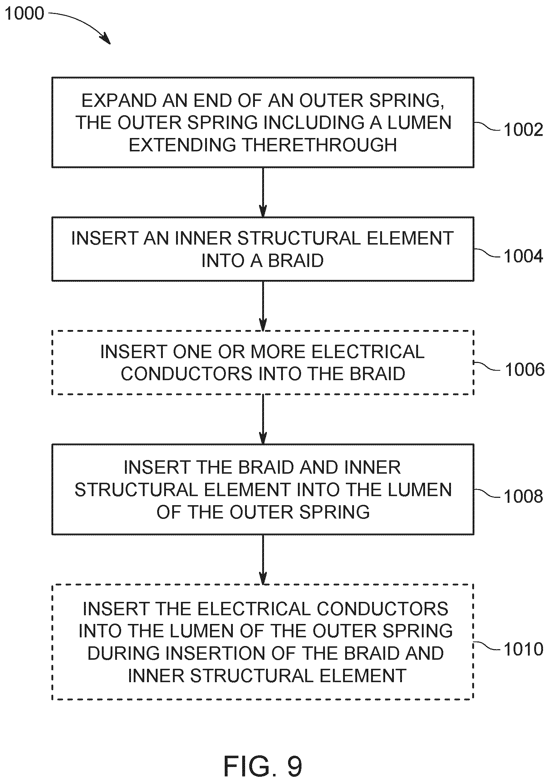

FIG. 9 illustrates a method 1000 of manufacturing a connection cable 100 in accordance with examples taught herein. In accordance with various examples taught herein, the steps of method 1000 can be executed sequentially or, in some cases, more than one step can be executed simultaneously. The method 1000 includes expanding an end of an outer spring 202 (step 1002). The outer spring includes a lumen 218 extending therethrough. The end of the outer spring 202 can then be clamped to maintain an expanded opening during subsequent steps of the manufacture. For example, the outer spring clamp 410 described above can be used to expand the end of the outer spring. The method includes inserting an inner structural element 204 into a braid 206 (step 1004). For example, the braid 206 can be attached to a thin but relatively stiff guide wire such as, for example, a solid steel wire of 0.2 mm diameter. The guide wire can be fed into expanded end of the outer spring 202, threaded through the outer spring 202, and pulled out of the opposite end. The braid 206 is then abutted with the expanded end of the outer spring 202. As the braid 206 abuts the expanded end of the outer spring 202, the inner structural element 204 is inserted or combined into the braid 206. The method 1000 also optionally includes inserting one or more electrical conductors 210 into the braid 206 (step 1006). Step 1006 can be performed before the braid is abutted with the outer spring or as the braid 206 is abutted with the outer spring 202, for example. In some examples, the electrical conductors 210 can be inserted into the braid 206 simultaneously with insertion of the inner structural element 204. The method 1000 includes inserting the braid 206 and inner structural element 204 into the lumen 218 of the outer spring 202 (step 1008). For example, the guide wire can be pulled from the cable end opposite to the expanded end to urge the braid and inner structural element into the cable. A combination of pulling on the guide wire and pushing the braid from the expanded end can be employed. The method 1000 also optionally includes inserting the electrical conductors 210 into the lumen 218 of the outer spring 202 during insertion of the braid 206 and inner structural element 204 (step 1010). For example, the electrical conductors 210 can be combined into the braid 206 as in step 1006 and then can be pulled by guide wire and/or pushed into the outer spring as described in step 1008.

While the present teachings are described in conjunction with various embodiments, it is not intended that the present teachings be limited to such embodiments. On the contrary, the present teachings encompass various alternatives, modifications, and equivalents, as will be appreciated by those of skill in the art.

The section headings used herein are for organizational purposes only and are not to be construed as limiting the described subject matter in any way.

In this detailed description of the various embodiments, for purposes of explanation, numerous specific details have been set forth to provide a thorough understanding of the embodiments disclosed. One skilled in the art will appreciate, however, that these various embodiments can be practiced with or without these specific details in some examples. In other instances, structures and devices are shown in block diagram form. Furthermore, one skilled in the art can readily appreciate that the specific sequences in which methods are presented and performed are illustrative and it is contemplated that the sequences can be varied (unless explicitly noted otherwise) and still remain within the spirit and scope of the various embodiments disclosed herein.

All literature and similar materials cited in this application, including but not limited to, patents, patent applications, articles, books, treatises, and internet web pages are expressly incorporated by reference in their entirety for any purpose. Unless described otherwise, all technical and scientific terms used herein have a meaning as is commonly understood by one of ordinary skill in the art to which the various embodiments described herein belongs.

It will be appreciated that there is an implied "about" prior to specific temperatures, concentrations, times, pressures, flow rates, cross-sectional areas, etc. discussed in the present teachings, such that slight and insubstantial deviations are within the scope of the present teachings. In this application, the use of the singular includes the plural unless specifically stated otherwise. Also, the use of "comprise", "comprises", "comprising", "contain", "contains", "containing", "include", "includes", and "including" are not intended to be limiting. It is to be understood that both the foregoing general description and the following detailed description are exemplary and explanatory only and are not restrictive of the present teachings.

As used herein, "a" or "an" also can refer to "at least one" or "one or more" in some instances unless expressly noted to the contrary. Also, the use of "or" is inclusive, such that the phrase "A or B" is true when "A" is true, "B" is true, or both "A" and "B" are true. Further, unless otherwise required by context, singular terms shall include pluralities and plural terms shall include the singular.

A "system" as used herein sets forth a set of components, real or abstract, comprising a whole where each component interacts with or is related to at least one other component within the whole.

Advantages and features of the present disclosure can be further described by the following examples:
Example 1. A connection cable for electrical and thermal connectivity in ultra-high vacuum, comprising: an outer spring including a lumen extending therethrough, the outer spring including vacuum conductance paths to enable evacuation of the lumen in a vacuum environment; a braid located at least partially within the lumen of the outer spring and configured to conduct high voltage and thermal energy; and an inner structural element disposed at least partially within the braid to maintain the shape of the connection cable.
Example 2. The connection cable of example 1, further comprising: a first section configured to enable motion of a connected stage in three translational dimensions and a first rotational dimension, the first section including the outer spring, the braid, and the inner structural element, and a second section configured to enable motion of the connected stage in a second rotational dimension, the second section including the braid.
Example 3. The connection cable of example 2, wherein the first section is formed into a helical shape and the second section is formed into a U-shape.
Example 4. The connection cable of any one of examples 2-3, further comprising an intermediate fixation that connects the first section to the second section.
Example 5. The connection cable of any one of examples 1-4, further comprising: an external interface connector to connect a first end of the connection cable to a thermal reservoir, a high voltage supply, and an electrical interface; and a sample interface connector to connect a second end of the connection cable to a stage of a charged particle system.
Example 6. The connection cable of any one of examples 1-5, further comprising one or more electrical conductors disposed within the outer spring and configured to carry electrical signals.
Example 7. The connection cable of example 6, wherein the plurality of electrical conductors comprises four electrical conductors.
Example 8. The connection cable of any one of examples 1-7, wherein a length of the connection cable is in a range from 300 millimeters to 500 millimeters.
Example 9. The connection cable of any one of examples 1-8, wherein the connection cable is configured to operate at pressures below 10⁻⁹ mbar.
Example 10. The connection cable of any one of examples 1-9, wherein the connection cable is configured to maintain a standoff distance to environmental components during motion of a connected stage inside a charged particle system.
Example 11. A method of manufacturing a connection cable that provides electrical and thermal connectivity in a high vacuum environment, the method comprising: expanding an end of an outer spring, the outer spring including a lumen extending therethrough; inserting an inner structural element into a braid; and inserting the braid and inner structural element into the lumen of the outer spring.
Example 12. The method of example 11, further comprising: inserting one or more electrical conductors into the braid; and inserting the electrical conductors into the lumen of the outer spring during insertion of the braid and inner structural element.
Example 13. The method of any one of examples 11-12, further comprising bending the connection cable into a helical shape to create vacuum conductance paths through a lateral surface of the outer spring.
Example 14. The method of any one of examples 11-13, wherein expanding the end of the outer spring includes driving the end of the outer spring between a wedge-shaped insert and a collar having a complementary shape.
Example 15. The method of any one of examples 11-14, wherein the outer spring defines a first section of the connection cable, the method further comprising passing the braid through a second section of the connection cable.
Example 16. A connection cable for electrical and thermal connectivity in ultra-high vacuum, comprising: a first section configured to enable motion of a connected stage in three translational dimensions and a first rotational dimension, the first section including: an outer spring including a first lumen extending therethrough, a braid disposed at least partially within the first lumen of the outer spring and configured to conduct high voltage and thermal energy, and an inner structural element disposed at least partially within the braid to maintain the shape of the first section; a second section configured to enable motion of the connected stage in a second rotational dimension, the second section including the braid; and an intermediate fixation that connects the first section and the second section.
Example 17. The connection cable of example 16, wherein the first section is formed into a helical shape and the second section is formed into a U-shape.
Example 18. The connection cable of any one of examples 16-17, wherein the connection cable is configured to maintain a standoff distance to environmental components during motion of a connected stage inside a charged particle system.
Example 19. The connection cable of any one of examples 16-18, further comprising one or more electrical conductors disposed within the first section and the second section and configured to carry electrical signals.
Example 20. The connection cable of any one of examples 16-19, further comprising: an external interface connector to connect a first end of the connection cable to a thermal reservoir, a high voltage supply, and an electrical interface; and a sample interface connector to connect a second end of the connection cable to a stage of a charged particle system.

## Claims

1. A connection cable for electrical and thermal connectivity in ultra-high vacuum, comprising:
an outer spring including a lumen extending therethrough, the outer spring including vacuum conductance paths to enable evacuation of the lumen in a vacuum environment;
a braid located at least partially within the lumen of the outer spring and configured to conduct high voltage and thermal energy; and
an inner structural element disposed at least partially within the braid to maintain the shape of the connection cable.

2. The connection cable of claim 1, further comprising:
a first section configured to enable motion of a connected stage in three translational dimensions and a first rotational dimension, the first section including the outer spring, the braid, and the inner structural element, and
a second section configured to enable motion of the connected stage in a second rotational dimension, the second section including the braid.

3. The connection cable of claim 2, wherein the first section is formed into a helical shape and the second section is formed into a U-shape.

4. The connection cable of claim 2 or claim 3, further comprising an intermediate fixation that connects the first section to the second section.

5. The connection cable of any one of claims 1-4, further comprising:
an external interface connector to connect a first end of the connection cable to a thermal reservoir, a high voltage supply, and an electrical interface; and
a sample interface connector to connect a second end of the connection cable to a stage of a charged particle system.

6. The connection cable of any one of claims 1-5, further comprising one or more electrical conductors disposed within the outer spring and configured to carry electrical signals.

7. The connection cable of claim 6, wherein the plurality of electrical conductors comprises four electrical conductors.

8. The connection cable of any one of claims 1-7, wherein a length of the connection cable is in a range from 300 millimeters to 500 millimeters.

9. The connection cable of any one of claims 1-8, wherein the connection cable is configured to operate at pressures below 10⁻⁸ mbar.

10. The connection cable of any one of claims 1-9, wherein the connection cable is configured to maintain a standoff distance to environmental components during motion of a connected stage inside a charged particle system.

11. A method of manufacturing a connection cable that provides electrical and thermal connectivity in a high vacuum environment, the method comprising:
expanding an end of an outer spring, the outer spring including a lumen extending therethrough;
inserting an inner structural element into a braid; and
inserting the braid and inner structural element into the lumen of the outer spring.

12. The method of claim 11, further comprising:
inserting one or more electrical conductors into the braid; and
inserting the electrical conductors into the lumen of the outer spring during insertion of the braid and inner structural element.

13. The method of any one of claims 11-12, further comprising bending the connection cable to create vacuum conductance paths through a lateral surface of the outer spring.

14. The method of any one of claims 11-13, wherein expanding the end of the outer spring includes driving the end of the outer spring between a wedge-shaped insert and a collar having a complementary shape.

15. The method of any one of claims 11-14, wherein the outer spring defines a first section of the connection cable, the method further comprising passing the braid through a second section of the connection cable.
